(19) Europäisches Patentamt / European Patent Office / Office européen des brevets

(11) **EP 4 756 434 A1**

(12) **EUROPEAN PATENT APPLICATION**

(43) Date of publication:
**10.06.2026 Bulletin 2026/24**

(21) Application number: **24217841.6**

(22) Date of filing: **05.12.2024**

(51) International Patent Classification (IPC):
**G01P 15/125** $^{(2006.01)}$  **G01P 15/18** $^{(2013.01)}$
**G01P 15/08** $^{(2006.01)}$

(52) Cooperative Patent Classification (CPC):
**G01P 15/125; B81B 3/0086; G01P 15/18;**
B81B 2201/0235; B81B 2201/033; B81B 2203/0307;
B81B 2203/051; G01P 2015/0814

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **Murata Manufacturing Co., Ltd.**
**Nagaokakyo-shi, Kyoto 617-8555 (JP)**

(72) Inventors:
• **RYTKÖNEN, Ville-Pekka**
  **01820 Klaukkala (FI)**
• **LIUKKU, Matti**
  **00320 Helsinki (FI)**
• **BLOMQVIST, Anssi**
  **00980 Helsinki (FI)**
• **FINNE, Antti**
  **01690 Vantaa (FI)**

(74) Representative: **Boco IP Oy Ab**
**Kansakoulukatu 3**
**00100 Helsinki (FI)**

(54) **ACCELEROMETER**

(57)    An accelerometer which comprises a first, second, third and fourth measurement cell. Each of the first, second, third and fourth measurement cells comprises a mass element which is mobile in the y-direction and first and second fixed structures. The mass element forms a differential capacitor with the first and second fixed structures. Each of the first, second, third and fourth measurement cells comprises a central line, and the first and second fixed structures are on opposite sides of the central line in each of the first, second, third and fourth measurement cells. The placement of the first and second capacitors with respect to the central line in the first and third measurement cells is the same. The placement of the first and second capacitors with respect to the central line in the second and fourth measurement cells is the same. The placement of the first and second capacitors with respect to the central line in the first measurement cell is opposite to the placement of the first and second capacitors with respect to the central line in the second measurement cell.

Fig. 3b

EP 4 756 434 A1

## Description

FIELD OF THE DISCLOSURE

The present disclosure relates to microelectromechanical (MEMS) accelerometers, and more particularly to accelerometers which measure acceleration in the device plane. The present disclosure further concerns the sensitivity of such accelerometers to external disturbances.

BACKGROUND OF THE DISCLOSURE

MEMS accelerometers typically contain a mobile mass element which is suspended from an adjacent fixed structure with flexible suspenders. The suspenders allow the mass element to move in relation to the fixed structures when the accelerometer undergoes acceleration.

The movement of the mobile mass element may be measured capacitively. The opposing electrodes which form a capacitor are formed on the mass element and on the adjacent fixed structure.

A MEMS accelerometer may, during its manufacturing and/or during its use, experience thermal and mechanical stress. Some parts of the accelerometer may be deformed due to such stress. The deformation may shift the relative positions of the two capacitor electrodes, which leads to inaccurate measurements.

The accelerometer and its package may be designed so that its sensitivity to stress is minimized, but it is difficult to completely eliminate deformation in devices which are used in high-stress environments, such as cars.

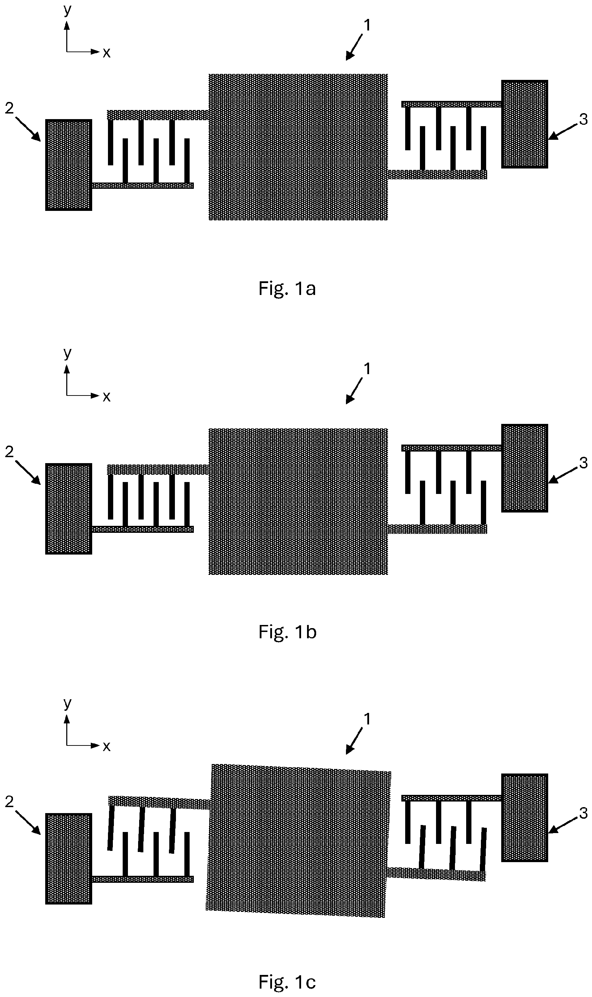

It is known that at least some of the harmful consequences of deformation can be reduced by designing the microstructures in the MEMS accelerometer a certain way. Differential measurement arrangements, for example, can electrically compensate for some forms of deformation effects, so that the output of the accelerometer may be unaffected (or affected just a little) by the deformation. This is illustrated in figures 1a - 1c.

Figure 1a illustrates a device with a mass element 1 and fixed structures 2 and 3. Comb capacitors are formed between the mass element and the two fixed structures. The mass element 1 is in its rest position in figure 1a, and no stress-induced deformation has yet occurred. A first capacitive signal S1 may be measured from the left capacitor and a second capacitive signal S2 may be measured from the right capacitor. The differential output signal S is the difference between these two signals, S = S1 - S2. This signal may be zero when the mass element 1 is in its rest position in figure 1a.

In figure 1b the mass element 1 has moved in the negative y-direction due to acceleration. S1 increase due to increasing overlap between the fingers of the capacitor, and S2 decreases due to decreasing overlap. The differential output signal S therefore increases and correctly indicates that acceleration is taking place.

In figure 1c the mass element 1 is in its rest position (there is no acceleration), but the relative positions of the mass element 1 and the fixed structures 2 and 3 have changed due to deformation. The mass element 1 has rotated in the xy-plane. Nevertheless, the differential output signal S = S1 - S2 is still zero because the deformation has reduced the overlap between fingers in both the left and right capacitors. The deformation is therefore not misinterpreted as acceleration, as it would be in a non-differential arrangement where only one measurement capacitor is used.

The differential capacitive structures can, due to their symmetry, automatically compensate for at least some deformation. An accelerometer with differential measurement arrangements can therefore, after deformation has taken place, measure acceleration more accurately than one which doesn't comprise differential measurement arrangements.

Document US10324106 discloses a device where a differential capacitive arrangement is employed with a single movable mass. However, there are many forms of deformation which cannot be compensated with this arrangement,

BRIEF DESCRIPTION OF THE DISCLOSURE

An object of the present disclosure is to provide an apparatus with a differential measurement arrangement. The object of the disclosure is achieved by an arrangement which is characterized by what is stated in the independent claim. The preferred embodiments of the disclosure are disclosed in the dependent claims.

The disclosure is based on the idea of utilizing four measurement cells, each with its own mass element. An advantage of the arrangement of the disclosure is that it allows a greater number of potential deformations to be compensated.

BRIEF DESCRIPTION OF THE DRAWINGS

In the following the disclosure will be described in greater detail by means of preferred embodiments with reference to the accompanying drawings, in which:

Figures 1a - 1c illustrate a differential measurement and deformation.
Figure 2a illustrates the device plane.
Figures 2b - 2g illustrate a measurement cell.
Figures 3a - 3f illustrate examples of quadruple differential measurement arrangements.
Figure 4 illustrates a more detailed accelerometer structure.
Figures 5a - 5c and 6a - 6c illustrate deformation in a quadruple differential arrangement.

DETAILED DESCRIPTION OF THE DISCLOSURE

This disclosure describes an accelerometer which comprises a first, second, third and fourth measurement cell in a device layer which defines an xy-plane. An x-axis and a y-axis divide the xy-plane into a first, second, third and fourth quadrant. The first and fourth quadrants lie on a first side of the y-axis, and the second and third quadrants lie on a second side of the y-axis, and the first and second quadrants line on a first side of the x-axis, and the third and fourth quadrants lie on a second side of the x-axis. The y-axis is orthogonal to the x-axis.

The first measurement cell lies in the first quadrant, the second measurement cell lies in the second quadrant, the third measurement cell lies in the third quadrant, and the fourth measurement cell lies in the fourth quadrant.

Each of the first, second, third and fourth measurement cells comprises: a mass element which is mobile in the y-direction, and a first fixed structure which comprises a first anchor point and a second fixed structure which comprises a second anchor point.

The mass element in each of the first, second, third and fourth measurement cells forms a first capacitor with the first fixed structure, and the capacitance of the first capacitor increases when said mass element moves in a positive y-direction and decreases when said mass element moves in a negative y-direction, which is opposite to the positive y-direction.

The mass element in each of the first, second, third and fourth measurement cells forms a second capacitor with the second fixed structure, and the capacitance of the second capacitor increases when said mass element moves in the negative y-direction and decreases when said mass element moves in the positive y-direction.

Each of the first, second, third and fourth measurement cells comprises a central line. The first and second anchor points are on opposite sides of the central line in each of the first, second, third and fourth measurement cells. The placement of the first and second anchor points with respect to the central line in the first and third measurement cells is the same. The placement of the first and second anchor points with respect to the central line in the second and fourth measurement cells is the same. The placement of the first and second anchor points with respect to the central line in the first measurement cell is opposite to the placement of the first and second capacitors with respect to the central line in the second measurement cell.

The device plane is illustrated and referred to as the xy-plane in this disclosure. The device plane is determined by the device layer. The device layer can be made of silicon. It may for example be formed by a silicon wafer, which may be called the device wafer or structure wafer. Alternatively, the device layer may be a silicon layer which has been deposited on a substrate. In either case, the mass element and at least some parts of the first and second fixed structures may be formed in the device layer. The device layer may be structurally supported by a separate, thicker support wafer or substrate.

The accelerometer may be configured to measure acceleration in the device plane, in the y-direction. In other words, it may be an in-plane accelerometer. Each measurement cell can, on its own, be used to measure acceleration in the y-direction. When signals from the four measurement cells are combined, as described in more detail below, the output becomes significantly less sensitive to deformations which may be induced for example by thermal and/or mechanical stress, such as high temperatures, temperature cycling or mechanical shocks.

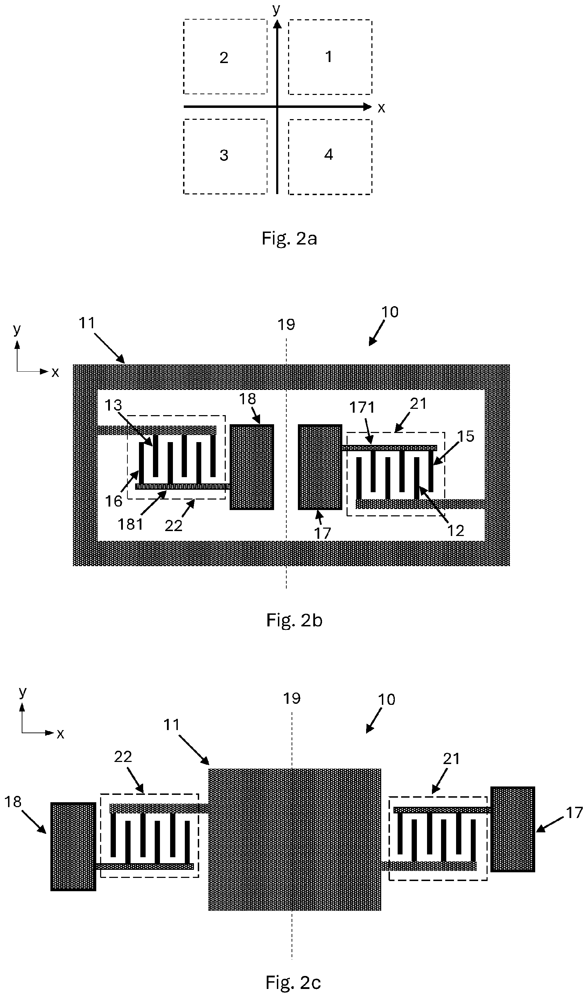

Figure 2a illustrates the device plane and the locations of the first (1), second (2), third (3) and fourth (4) quadrants in relation to the x-axis and the y-axis. Some figures in this disclosure illustrate only a single measurement cell. In those figures the orientation of the x- and y-directions with respect to the illustrated device parts are indicated with small axis symbols in the top left corner of the figure. In figures where all four measurement cells are illustrated, the x-axis and y-axis are shown in full. The crossing point of the x- and y-axes lie in the middle of the illustrated four-cell device.

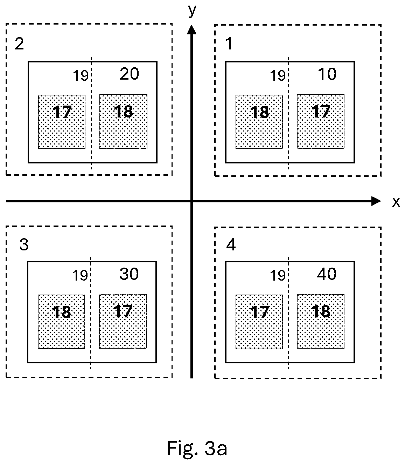

Figure 2b illustrates a first measurement cell 10. All options which are discussed below with reference to figures 2b - 2g and illustrated schematically in the first measurement cell 10 in these figures, may also be implemented in the same way in the second, third and fourth measurement cells. However, there is one exception: as described in detail below with reference to figures 3a - 3e, the placement of the first (17) and second 18 anchor points with respect to the central line 19 is not the same in all four measurement cells.

The measurement cell 10 includes a mass element 11, a first fixed structure which includes the first anchor point 17, and a second fixed structure which includes the second anchor point 18. In figures 2b - 2g, the first fixed structure comprises a first fixed beam 171 which extends outward from the first anchor point 17, and a second fixed beam 181 which extends outward from the second anchor point 18. The fixed structure also comprises fixed comb fingers which are attached to the corresponding fixed beam. However, the first and second fixed structures could, in addition to the first and second anchor points 17 and 18, comprise fixed parts with many different shapes. Furthermore, the capacitors do not necessarily have to utilize finger-shaped comb electrodes. They may alternatively utilize flat parallel plate electrodes formed in the first and second fixed structures.

The mass element 11 may surround the first and second fixed structures in the xy-plane in each of the first, second, third and fourth measurement cells, as figure 2b illustrates.

Throughout this disclosure, the term "mass element" refers to a part of the device layer which is not fixed. The mass element 11 may be suspended from adjacent fixed structures with flexible suspenders which allow the mass element 11 to move in relation to the first and second fixed structures when the accelerometer experiences acceleration. In particular, the suspenders may allow the mass element 11 to move in the positive and negative y-directions. The fixed structures from which the mass element is suspended may be the first and second anchor points 17 and 18, but it is also possible to utilize other fixed structures for this purpose.

Throughout this disclosure, the term "fixed structure" refers to a part of the accelerometer which is fixed. In other words, the fixed structure does not move with respect to the surrounding fixed parts of the accelerometer (such as the package) when the accelerometer experiences acceleration. The mass element, on the other hand, does move with respect to such parts.

The fixed structure may lie at least partly in the device layer. Some parts of the fixed structure may be anchored to an adjacent support structure (for example a support wafer) with a rigid structure which extends in the z-direction from the device wafer to the support structure. These anchored parts may be called anchor points. Other parts of the fixed structure, which are not anchored, may simply be rigid structures in the device layer.

Acceleration in the y-direction may be detected with capacitive transducers. The capacitance of each transducer may change when the accelerometer undergoes acceleration and the mass element 11 moves away from its initial rest position. The rest position may be the position where the mass element 11 is located when there is no acceleration in the y-direction. Each capacitive transducer may comprise a first capacitor or a second capacitor. The accelerometer may comprise a control unit which is configured to retrieve capacitive signals from the capacitive transducers, as discussed in more detail below.

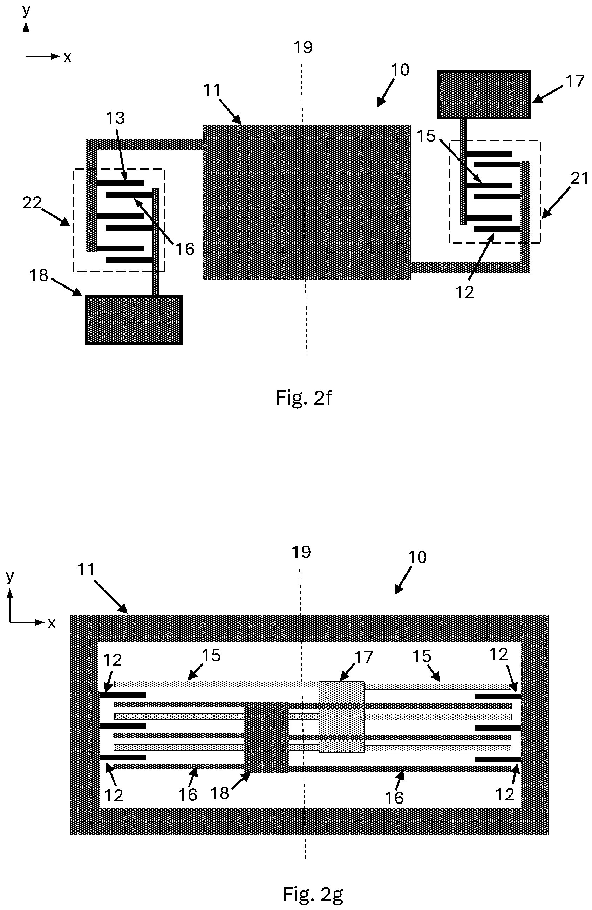

The mass element 11 in the first measurement cell 10 in figure 2b forms a first capacitor 21 with the first fixed structure and a second capacitor 22 with the second fixed structure. The illustrated capacitors 21 and 22 comprise a first set 12 and a second set 13 of mobile combs on the mass element 11, and a first set 15 of fixed combs on the first fixed structure and a second set 16 of fixed combs on the second fixed structure. Both the fixed and mobile combs have an elongated shape, and they are in this case parallel to the y-axis. The fixed and mobile comb sets are interdigitated with each other. However, the comb geometry illustrated in figure 2b is only one possible alternative. Figures 2f and 2g illustrates other possibilities. As mentioned previously, conductive structures with other shapes can also be used to form the first and second capacitors.

The mass element 11 and the first and second fixed structures and may be made of silicon. They may be sufficiently conductive to function as the electrodes of the first and second capacitors 21 and 22 without needing any additional materials in the capacitor regions.

It can be seen in figure 2b that the first and second capacitors 21 and 22 form a differential pair. In other words, the capacitance of the first capacitor 21 increases when the mass element 11 moves in the positive y-direction (because the overlap between the fixed and mobile combs increases), and the capacitance of the second capacitor 22 decreases when the mass element 11 moves in the positive y-direction (because the same overlap decreases). When the mass element 11 moves in the negative direction, the capacitance decreases in the first capacitor 21 and increases in the second capacitor 22. The first and second capacitors 21 and 22 in figures 2c - 2f also form differential pairs in the same manner.

Figure 2c illustrates an alternative geometry where the mass element 11 occupies a central position in the first measurement cell 10 and the fixed structures and capacitors 21 and 22 are located to the left and right of the mass element 11. The mass element may alternatively have any other suitable geometry. It may for example partly surround the fixed structures, or the fixed structures may partly surround the mass element.

The first measurement cell 10 in figures 2b - 2g comprises a central line 19. The central line may cross the geometric center of the first measurement cell, but it does not necessarily have to be cross the center. The central line 19 may be, but does not necessarily have to be, parallel to the y-axis or to the x-axis. The first (17) and second (18) anchor point are placed on opposite sides of the central line 19. Figures 2b - 2c and 2f - 2g illustrate measurement cells where the central line 19 is parallel to the y-axis. The x-coordinates of the first (17) and second (18) anchor points are different from each other when the central line 19 is parallel to the y-axis.

The y-coordinates of the first (21) and second (22) capacitors may be substantially equal. In other words, the first (21) and (second) capacitors may have the same length in the y-direction, and they may be aligned with each other so that the bottom end of the first capacitor 21 has the same y-coordinate as the bottom end of the second capacitor 22, as figure 2c, for example, illustrates. However, the y-coordinates do not need to be exactly equal, as figure 2b, for example, illustrates.

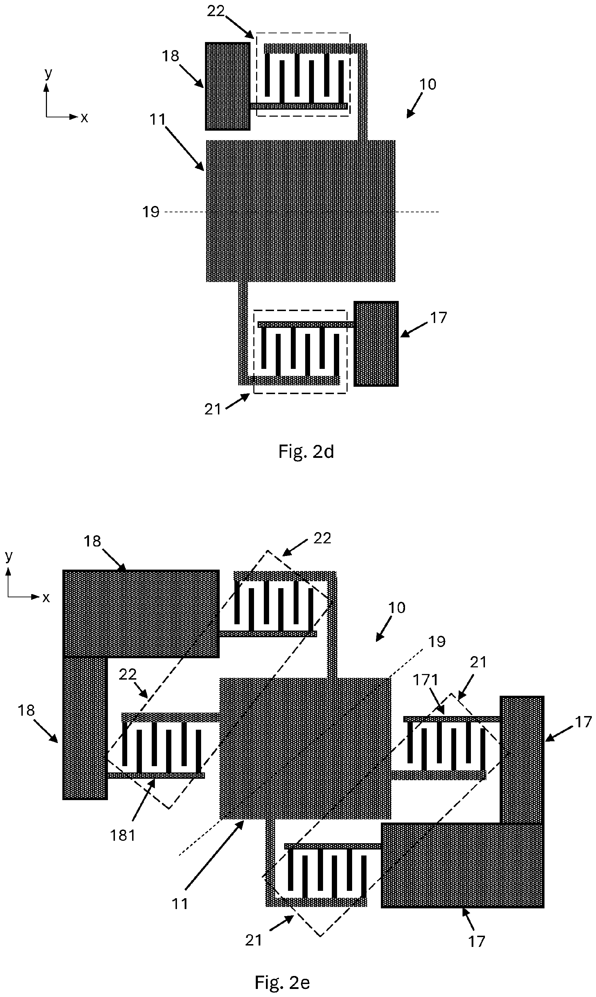

Figure 2d illustrate an alternative arrangement where the central line 19 is parallel to the x-axis. The mass element 11 is mobile in the y-direction, just as before, and the capacitance of the first and second capacitors still increases or decreases with the movement of the mass element 11 in this direction, as described above. The only difference compared to figures 2b and 2c is that the y-coordinates of the first (21) and second (22) capacitors are different in this arrangement. The considerations presented in the previous paragraph on the y-coordinates of the first (21) and second (22) capacitors in figures 2b - 2c and 2f apply also to the x-coordinates of the first (21) and second (22) capacitors in figure 2d.

Figure 2e illustrates a third option where the central line 19 is not parallel to the x-axis, nor to the y-axis.

Instead, the central line 19 in this case forms an acute angle with both the x-axis and the y-axis. This acute angle may for example be in the range of 30-60 degrees.

The mass element 11 in figure 2e is mobile in the y-direction, and the capacitance of the first (21) and second (22) capacitors increases or decreases with the movement of the mass element 11 in this direction. The first (21) and second (22) capacitors are on opposite sides of the central line 19 also in figure 2e.

The first (17) and second (18) anchor points are on opposite sides of the central line 19 in all figures 2b - 2g.

The fixed and mobile combs in figures 2b - 2e all have an elongated shape, and they are parallel to the y-axis. This may be called a linear comb geometry.

In the linear comb geometry, each first capacitor 21 may comprise a first set of fixed combs 15 on the at least one fixed structure and a first set of movable combs 12 on the mass element 11. The first sets of fixed (15) and movable (12) combs may be oriented in the y-direction and interdigitated with each other. Each second capacitor 22 may comprises a second set of fixed combs 16 on the at least one fixed structure and a second set of movable combs 13 on the mass element 11. The second sets of fixed (16) and movable (13) combs may be oriented in the y-direction and interdigitated with each other.

Figure 2f illustrates an alternative arrangement where the comb fingers are instead parallel to the x-axis. The mass element 11 still moves in the y-direction, as before. Figure 2f shows multiple combs arranged next to each other, but the arrangement could instead comprise just a single capacitive plate on each fixed structure and a corresponding single capacitive plate on each side of the mass element 11. The surfaces of these capacitive plates would then be parallel to the x-axis. This may be called a parallel-plate capacitor. Other capacitive arrangements, which may for example include mixtures of linear comb and parallel-plate geometries, are also possible.

In the parallel-plate geometry, each first capacitor 21 may comprises a first set of fixed combs 15 on the first fixed structure and a first set of movable combs 12 on the mass element. The first sets of fixed (15) and movable (12) combs are oriented in the x-direction and interdigitated with each other. Each second capacitor 22 comprises a second set of fixed combs 16 on the second fixed structure and a second set of movable combs 13 on the mass element 11. The second sets of fixed (16) and movable (13) combs are oriented in the x-direction and interdigitated with each other.

Figure 2g illustrates another alternative arrangement where the first and second fixed structures so that each movable comb (12) is used both as an electrode in the first capacitor and as an electrode in the second capacitor. Each movable comb 12 is flanked by a first fixed comb 15 (which is a part of the first fixed structure) in the positive y-direction and by a second fixed comb 16 (which is a part of the first fixed structure) in the negative y-direction.

To achieve the configuration illustrated in figure 2g, while keeping the first and second fixed structures electrically isolated from each other, the first and second fixed structures may in some locations of the xy-plane extend past each other at different vertical z-coordinates. In figure 2g the first and second fixed structures have been drawn as partly overlapping structures in the xy-plane, but they may be located at different z-coordinates at each point of overlap, so that they don't come into contact with each other.

The arrangement illustrated in figure 2g differs from the previous ones in that it utilizes the same combs 12 in both the first and second capacitors. In the arrangement illustrated in figure 2g, as in the other arrangements illustrated in this disclosure, the capacitance of the first capacitor (between combs 12 and 15) increases when said mass element moves in a positive y-direction and the capacitance of the second capacitor (between combs 12 and 16) increases when said mass element moves in a negative y-direction. The combs are interdigitated so that each movable comb 12 is flanked by combs 15 and 16 on opposite sides. One first fixed comb 15 and one second fixed comb 16 lies between each pair of movable combs 12.

In other words, in the embodiments shown in figure 2g each first capacitor comprises a first set of fixed combs 15 on the first fixed structure and a set of movable combs 12 on the mass element. Each second capacitor comprises a second set of fixed combs 16 on the second fixed structure and the set of movable combs 12 on the mass element. The first (15) and second (16) second sets of fixed combs and the set of movable combs 12 are oriented in the x-direction. Each movable comb 12 in the set of movable combs is flanked one side by a comb from the first set of fixed combs 15 and flanked on the other side by a comb from the second set of fixed combs 16.

Figure 3a illustrates first (10), second (20), third (30) and fourth (40) measurement cells in the xy-plane. Numbers 1, 2, 3 and 4 mark the first, second, third and fourth quadrants, respectively. The central line 19 and the locations of the first (17) and second (18) anchor points with respect to the central line 19 are illustrated in each measurement cell.

Figure 3a illustrates a first example of a quadruple differential measurement arrangement, where the first and second anchor points have been arranged according to a first scheme.

It can be seen that the anchor point locations in this scheme correspond to those illustrated in figures 2b - 2c and 2f - 2g.

The measurement arrangement in each cell is configured to measure acceleration in the direction of the y-axis. Since the capacitance of each first capacitor 21 increases when the corresponding mass element moves in a positive y-direction and decreases when said mass element moves in a negative y-direction, and since the capacitance of each second capacitor 22 increases when the mass element moves in the negative y-direction, and decreases when said the element moves in the positive y-direction, each measurement cell comprises a single differential measurement arrangement for acceleration in the y-direction.

The placement of the first (17) and second (18) anchor points with respect to the central line 19 in the first (10) and third (30) measurement cells is the same. In other words, the first anchor point 17 is to the right of the central line 19 and the second anchor point 18 is to the left in these cells.

The placement of the first (17) and second (18) anchor points with respect to the central line 19 in the second (20) and fourth (40) measurement cells is the same. In other words, the first anchor point 17 is to the left of the central line 19 and the second anchor point 18 is to the right in these cells.

The placement of the first (17) and second (18) anchor points with respect to the central line 19 in the first measurement cell 10 is opposite to the placement of the first (17) and second (18) anchor points with respect to the central line 19 in the second measurement cell 20. In other words, the first anchor point 17 is to the right of the central line 19 and the second anchor point 18 is to the left in measurement cell 10, but in measurement cell 20 the first anchor point 17 is to the left of the central line 19 and the second anchor point 18 is to the right.

Consequently, the placement of the first (17) and second (18) anchor points with respect to the central line 19 in the first measurement cell 10 is also opposite to the placement of the first (17) and second (18) anchor points with respect to the central line 19 in the fourth measurement cell 40. And the placement of the first (17) and second (18) anchor points with respect to the central line 19 in the third measurement cell 30 is opposite to the placement of the first (17) and second (18) anchor points with respect to the central line 19 in both the second measurement cell 20 and in the fourth measurement cell 40.

In other words, if the first (17) and second (18) anchor points and the central line 19 form a unit, and we move from one quadrant to the next (either in a clockwise or counterclockwise order), then the orientation of the unit in the next quadrant is obtained by starting from the orientation of the unit in the present quadrant and rotating the unit 180 degrees about an axis which is perpendicular to the xy-plane. This applies to any embodiment presented in this disclosure.

Another way to describe the symmetry illustrated in figure 3a is that the central line 19 is parallel to the y-axis and, when the positions of different anchor points are compared, the first anchor point 17 in the third measurement cell 30 faces the first anchor point in the fourth measurement cell 40 across the y-axis. The first anchor point 17 in the fourth measurement cell 40 faces the second anchor point 18 in the first measurement cell 10 across the x-axis. The second anchor point 18 in the first measurement cell 10 faces the second anchor point 18 in the second measurement cell 20 across the y-axis.

However, the same symmetry could also be achieved by switching the positions of all first and second measurement capacitors in all four measurement cells 10 - 40. The symmetry would effectively be the same, but each instance of "first anchor point" in the preceding paragraph should be substituted with "second anchor point", and vice versa.

The symmetry and placement of first and second anchor points 17 and 18 described above may apply also the first and second capacitors 21 and 22. This is the case in all embodiments where the first capacitor 21 is on the same side of the central line 19 as the first anchor point 17, and where the second capacitor 22 is on the same side of the central line 19 as the second anchor point 18.

However, the placement of the first (17) and second (18) anchor points with respect to the central line 19 does not necessarily have to correspond to the placement of the first (21) and second (22) capacitors with respect to the central line 19. In any of the schematically illustrated embodiments in figures 2b - 2g, the mass element, fixed structures and anchor points may in practice be implemented with much more complicated geometries. Finding the optimal placements and geometry can be a complex design problem where many factors must be taken into account. Nevertheless, the stress-related benefits described in this disclosure are obtained with any embodiment described in this disclosure.

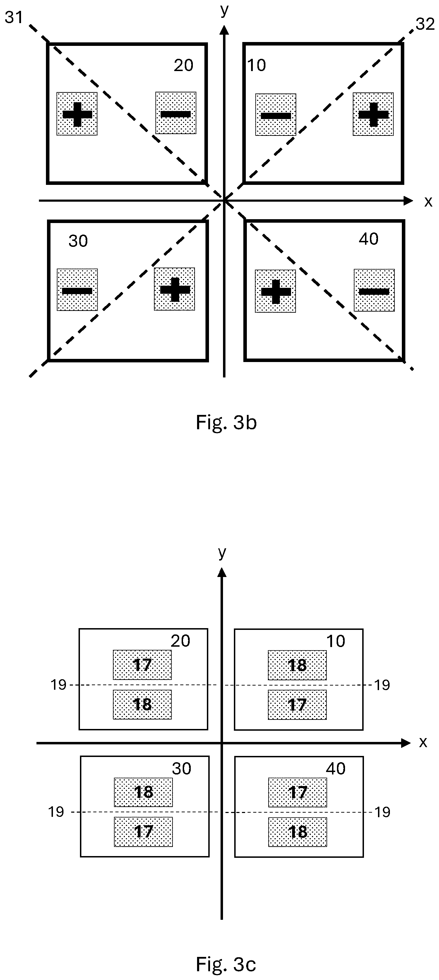

Figure 3b shows an alternative depiction of the symmetry described above. Each first anchor point is illustrated with a plus-sign and each second anchor point is illustrated with a minus-sign. The plus and minus signs may symbolize the polarity of the electrical signal which may be retrieved from the corresponding capacitor via this anchor point. Figure 3b also illustrates four lines: the x-axis, the y-axis and two diagonal lines 31 and 32. A measurement arrangement may be considered differentially symmetric with respect to a given line in the xy-plane if:

$$Np1 - Nm1 = Nm2 - Np2,$$

where Np1 is the number of plus-signs on a first side of the line, Nm1 is the number of minus-signs on the first side of the line, Np2 is the number of plus-signs on a second side (opposite to the first) of the line and Nm2 is the number of minus-signs on the second side of the line.

It can be seen in figure 3b that, if we select either the x-axis or the y-axis as the line of interest, then Np1 - Nm1 = Nm2 - Np2 = 0 since the number of pluses and minuses is two in each case. If we select either of the diagonal lines 31 or 32 as the lines of interest, the equation Np1 - Nm1 = Nm2 - Np2 still holds because either Np1 = 3, Nm1 = 1, Nm2 = 3 and Np2 = 1, or Np1 = 1, Nm1 = 3, Nm2 = 1 and Np2 = 3.

Consequently, the arrangement illustrated in figures 3a - 3b exhibits a quadruple differential symmetry:

with respect to the x-axis, the y-axis, and to the diagonal lines 31 and 32. Both the line 31 and the line 32 form an oblique angle with both the x-axis and the y-axis. These angles may, but do not necessarily have to, be 45 degrees. This also applies in the other examples presented in this disclosure.

Figure 3c illustrates a second example of a quadruple differential measurement arrangement, where the first and second capacitors have been arranged according to a second scheme. It can be seen that the capacitor locations in this scheme correspond to that illustrated in figure 2d.

The measurement arrangement in each cell in figure 3c is configured to measure acceleration in the direction of the y-axis and each measurement cell comprises a single differential measurement arrangement for acceleration in the y-direction.

It can be seen that the arrangement in figure 3c fulfils the same conditions as the one shown in figure 3a. That is, the placement of the first (17) and second (18) anchor points with respect to the central line 19 in the first (10) and third (30) measurement cells is the same. In other words, the first anchor point 17 is below the central line 19 and the second anchor point 18 is above the central line 19 in these cells.

The placement of the first (17) and second (18) capacitors with respect to the central line 19 in the second (20) and fourth (40) measurement cells is also the same. In other words, the first anchor point 17 is above the central line 19 and the second anchor point 18 is below the central line 19 in these cells.

Finally, the placement of the first (17) and second (18) anchor points with respect to the central line 19 in the first measurement cell 10 is opposite to the placement of the first (17) and second (18) anchor points with respect to the central line 19 in the second measurement cell 20. In other words, the first anchor point 17 is below the central line 19 and the second anchor point 18 is above the central line 19 in measurement cell 10. In measurement cell 20, the first anchor point 17 is above the central line 19 and the second anchor point 18 is below the central line 19.

It follows that the placement of the first (17) and second (18) anchor points with respect to the central line 19 in the first measurement cell 10 is also opposite to the placement of the first (17) and second (18) anchor points with respect to the central line 19 in the fourth measurement cell 40. And the placement of the first (17) and second (18) anchor points with respect to the central line 19 in the third measurement cell 30 is opposite to the placement of the first (17) and second (18) anchor points with respect to the central line 19 in both the second measurement cell 20 and in the fourth measurement cell 40.

Another way to describe the symmetry in the second example shown in figure 3c is that the central lines 19 are parallel to the x-axis and, when the positions of different anchor points are compared, the anchor point 17 in the first measurement cell 10 faces the first anchor point 17 in the fourth measurement cell 40 across the x-axis, and the first anchor point 17 in the first measurement cell 10 faces the second anchor point 18 in the second measurement cell 20 across the y-axis, and the second anchor point 18 in the third measurement cell 30 faces the second anchor point 18 in the second measurement cell 20 across the x-axis.

However, the same symmetry could also be achieved by switching the positions of all first (17) and second (18) anchor points in all four measurement cells 10 - 40. The symmetry would effectively be the same, but each instance of "first anchor point" in the preceding paragraph should be substituted with "second anchor point," and vice versa.

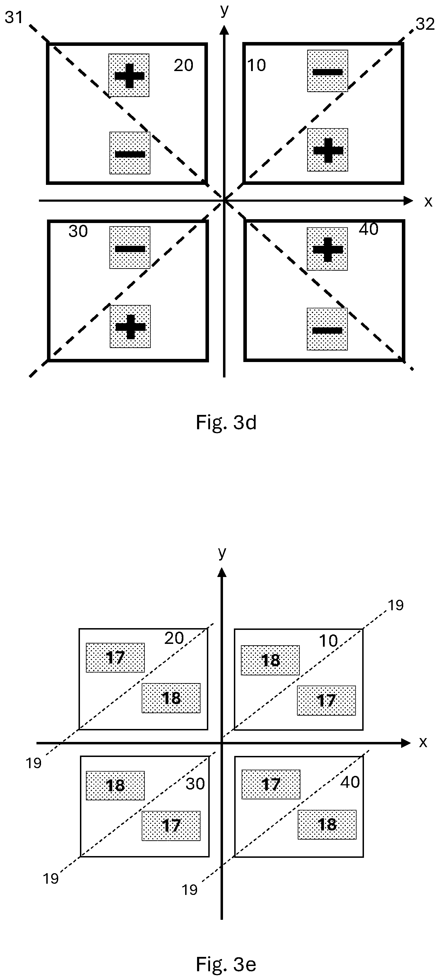

Figure 3d corresponds to the arrangement shown in figure 3c, but first anchor points 17 are illustrated with plus-signs and second anchor points 18 with minus-signs. It can be verified that the symmetry relationship:

$$Np1 - Nm1 = Nm2 - Np2$$

holds for the x-axis, the y-axis and for the two diagonal lines 31 and 32. Consequently, the arrangement illustrated in figures 3c - 3d exhibits a quadruple differential symmetry: with respect to the x-axis, the y-axis, and the diagonal lines 31 and 32.

Figure 3e illustrates a third example of a quadruple differential measurement arrangement, where the first and second anchor points have been arranged according to a third scheme.

It can be seen that the capacitor locations in this scheme correspond to that illustrated in figure 2e.

The measurement arrangement in each cell in figure 3e is configured to measure acceleration in the direction of the y-axis and each measurement cell comprises a single differential measurement arrangement for measuring acceleration in the y-direction.

It can be seen that the arrangement in figure 3e fulfils the same conditions as the ones shown in figures 3a and 3c. That is, the placement of the first (17) and second (18) anchor points with respect to the central line 19 in the first (10) and third (30) measurement cells is the same and the placement of the first (17) and second (18) anchor points with respect to the central line 19 in the second (20) and fourth (40) measurement cells is the same. The placement of the first (17) and second (18) anchor points with respect to the central line 19 in the first measurement cell 10 is also opposite to the placement of the first (17) and second (18) anchor points with respect to the central line 19 in the second measurement cell 20.

The placement of the first (17) and second (18) capacitors with respect to the central line 19 in the first measurement cell 10 is therefore also opposite to the placement of the first (17) and second (18) anchor points with respect to the central line 19 in the fourth measurement cell 40. And the placement of the first (17) and second (18) anchor points with respect to the central line 19 in the third measurement cell 30 is opposite to the placement of the first (17) and second (18) anchor points with respect to the central line 19 in both the second measurement cell 20 and in the fourth measurement cell 40.

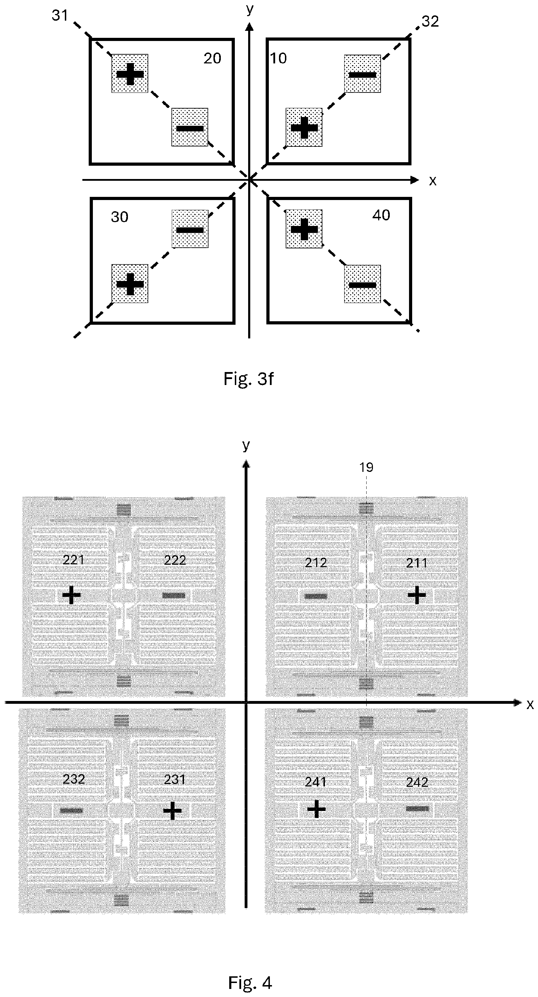

Figure 3f corresponds to the arrangement shown in figure 3e, but first capacitors 21 are illustrated with plus-signs and second capacitors 22 with minus-signs. It can be verified that the symmetry relationship:

$$Np1 - Nm1 = Nm2 - Np2$$

again holds for the x-axis, the y-axis and for the two diagonal lines 31 and 32. Consequently, the arrangement illustrated in figures 3e - 3f exhibits a quadruple differential symmetry: with respect to the x-axis, the y-axis, and the diagonal lines 31 and 32.

Optionally, in any embodiment presented in this disclosure, the capacitance of each first capacitor in each measurement cell may be substantially equal to the capacitance of the second capacitor in the same measurement cell when the mass element in said measurement cell is in its rest position. An additional option is that the capacitances of all first and second capacitors in the first, second, third and fourth measurement cells may be substantially equal when all mass elements are in their rest positions.

Figure 4 illustrates an accelerometer where the mass elements surround the first and second fixed structures as in figure 2b, and where the placement of the first and second anchor points (located at the plus and minus signs) with respect to the central line in each measurement cell corresponds to figure 3a.

It can be seen in figure 4 that the structural details (the microstructured pattern visible in the figure) of the first (211) and second (212) capacitors in the first measurement cell are not reflection-symmetric with each other with respect to the central line 19. Neither are the patterns of the first (221, 231, 241) and second (222, 232, 242) capacitors in the second, third and fourth measurement cells reflection-symmetric with each other with respect to the central lines in these measurement cells.

However, it can be seen in figure 4 the structural details of the two capacitors 211+212 in the first measurement cell, when taken together, are reflection-symmetric with the structures of the two capacitors 221+222, when taken together, in relation to the y-axis. The same symmetry is obtained between capacitor pair 231+232 and 241+242.

In other words, the structural patterns of the first (211) and second (212) capacitors in the first measurement cell may together be substantially reflection-symmetric with the structural patterns of the first (221) and second (222) capacitors in the second measurement cell with respect to the y-axis. The structural patterns of the first (231) and second (232) capacitors in the third measurement cell may together be substantially reflection-symmetric with the structural patterns of the first (241) and second (242) capacitors in the fourth measurement cell with respect to the y-axis.

Furthermore, it can also be seen in figure 4 that the structural details of the two capacitors 211+212 in the first measurement cell, when taken together, are reflection-symmetric with the structures of the two capacitors 241+242, when taken together, in relation to the x-axis. The same symmetry is obtained between capacitor pair 221+222 and 231+232.

In other words, the structural patterns of the first (211) and second (212) capacitors in the first measurement cell may together be substantially reflection-symmetric with the structural patterns of the first (241) and second (242) capacitors in the fourth measurement cell with respect to the x-axis. The structural patterns of the first (221) and second (222) capacitors in the second measurement cell are together substantially reflection-symmetric with the structural patterns of the first (231) and second (232) capacitors in the third measurement cell with respect to the x-axis. This symmetry may also be implemented in the example shown in figure 3c.

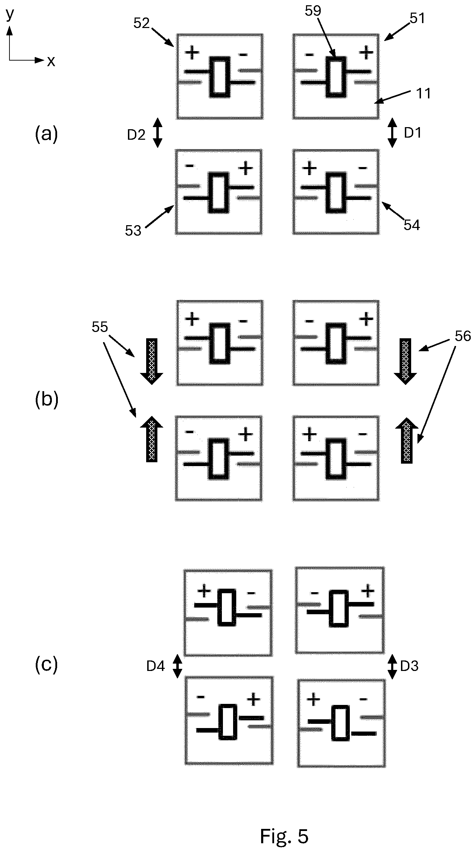

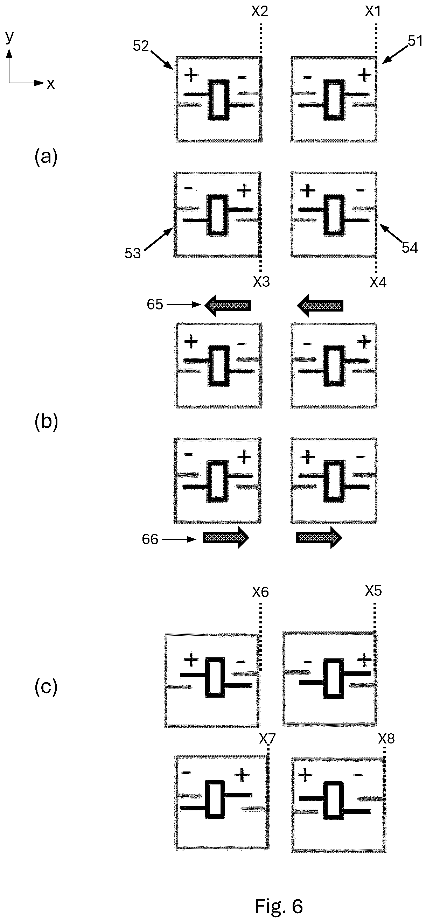

Figures 5a - 5c and 6a - 6c illustrate the benefits of a quadruple differential measurement arrangement schematically. Four measurement cells 51 - 52 are illustrated. A mass element 11 (see figure 5a) surrounds the first and second anchor points (which are here illustrated together by the box 59) in each measurement cell. The first capacitor in each cell is marked with a plus sign, and the second capacitor with a minus sign. Each capacitor is illustrated with just a single finger electrode on both the mass element 11 and on the fixed structure 17 for clarity. The capacitance of each capacitor increases when the two electrodes move closer to each other in the y-direction and/or when their overlap in the x-direction increases. Conversely, the capacitance of each capacitor decreases when the two electrodes move further away from each other in the y-direction and/or when their overlap in the x-direction decreases.

The placement of the first and second capacitors corresponds in figures 5a - 5c and 6a - 6c to the arrangement illustrated in figures 3a - 3b. Figure 5a illustrates the relative position of each mass element with respect to the corresponding fixed structure before any deformation has taken place. The mass elements are shown in their rest positions, where no acceleration is present. The distance between the mass elements in measurement cells 51 and 54 in the y-direction is D1, while the distance between the mass elements in measurement cells 52 and 53 in the y-direction is D2. D1 may be equal to D2, but it does not necessarily have to be equal.

Figure 5b illustrates with arrows a deformation event 55/56 which changes the positions of the mass elements with respect to the positions of the corresponding fixed structures. Figure 5c illustrates the positions of the mass elements after the deformation event has taken place. The mass elements in measurement cells 51 and 52 have been moved downward (to a smaller y-coordinate) in relation to their respective fixed structures, while mass elements in measurement cells 53 and 54 have been moved upward (to a greater y-coordinate). Consequently, D3 < D1 and D4 < D2.

The deformation event 55/56, and the corresponding deformation event 65/66 illustrated in figure 6c, may for example occur due to thermal stress, mechanical stress, or ageing. High temperatures, temperature cycling or reduced integrity due to mechanical shocks may be the underlying cause. Although the deformation is here illustrated as a simple linear movement, it may in practice be a more complicated combination of expansion, contraction, twisting and/or bending in various parts of the accelerometer.

It can be seen from the capacitors in figure 5c that each increase in the capacitance of a first capacitor is matched by a corresponding decrease in another first capacitor. Correspondingly, each increase in the capacitance of a second capacitor is matched by a corresponding decrease in another second capacitor. Consequently, the effect of the deformation on the output of the accelerometer is at least to some extent automatically cancelled - that is, when the structure illustrated in figure 5c experiences acceleration, the output signal be close to the output signal which would have been obtained when the undeformed structure in figure 5a experiences acceleration. The same compensation occurs also if the event includes 55 but not 56, or if it includes 56 but not 55.

The cancellation may not always be perfect since, due to possible irregularities in the geometry of the deformation event, the magnitude of one increase may not be perfectly matched by the magnitude of another decrease. But even partial cancellation is a good beginning. Other measures may be taken, for example in the signal processing stage, to further reduce the disturbance produced by the deformation event.

Figure 6a again illustrates the relative position of each mass element with respect to the corresponding fixed structure before any deformation has taken place. The mass elements are shown in their rest positions when no acceleration is present. The x-coordinates of the (right edges) of the mass elements in measurement cells 51 and 52 (with respect to the corresponding fixed structure) have been labelled X1 and X2, respectively. The x-coordinates of the (right edges) of the mass elements in measurement cells 53 and 54 have been labelled X3 and X4, respectively - the reference points is here too the corresponding fixed structure.

Figure 6b illustrates with arrows a deformation event 65/66 which changes the positions of the mass elements with respect to the positions of the corresponding fixed structures. Figure 6c illustrates the positions of the mass elements after the deformation event has taken place. The mass elements in measurement cells 51 and 52 are shifted to the left (to a smaller x-coordinate) in relation to their respective fixed structures, while the mass elements in measurement cells 53 and 54 have been moved to the right (to a greater x-coordinate). Consequently, X5 < X1 and X6 < X2, while X8 > X4 and X7 > X3, where each x-coordinate is expressed in relation to the position of the corresponding fixed structure.

It can be seen from the capacitors in figure 6c that each increase in the capacitance of a first capacitor (due to increased overlap in the x-direction) is matched by a corresponding decrease in another first capacitor (due to decreased overlap). Correspondingly, each increase in the capacitance of a second capacitor is matched by a corresponding decrease in another second capacitor. Consequently, the effect of the deformation on the output of the accelerometer is again cancelled, at least to some extent.

The same compensation occurs also if the event includes 65 but not 66, or if it includes 66 but not 65. Furthermore, compensation is achieved with any combination of deformations 55, 56, 65 and 66.

The same general principles of differential compensation are also gained with the capacitor placements illustrated in figures 3c - 3d and 3e - 3f. Furthermore, the deformation events may alternatively include relative displacement in the diagonal directions 31 and 32 illustrated in figure 3b, 3d and 3f. The symmetry relationship discussed above;

$$Np1 - Nm1 = Nm2 - Np2,$$

creates a differential compensation in a large variety of possible deformations in various directions.

As mentioned earlier, the accelerometer may comprise a control unit. The control unit may be configured to retrieve first and second capacitive signals from each first and second capacitor.

S11 may designate the first capacitive signal obtained from the first capacitor in the first measurement cell and S12 may designate the second capacitive signal obtained from the second capacitor in the first measurement cell. Correspondingly, S21, S31 and S41 may designate the first capacitive signals obtained from the first capacitors in the second, third and fourth measurement cells, while S22, S32 and S42 may designate the second capacitive signals obtained from the second capacitors in the second, third and fourth measurement cells, respectively. The control unit may be configured to add and subtract these signals in the digital domain so that the output signal of the accelerometer is a quadruple differential signal S = S11 - S12 + S21 - S22 + S31 - S32 + S41 - S42.

**Claims**

1.  An accelerometer which comprises a first, second, third and fourth measurement cell in a device layer which defines an xy-plane, wherein an x-axis and a y-axis divide the xy-plane into a first, second, third and fourth quadrant, so that the first and fourth quadrants lie on a first side of the y-axis, and the second and third quadrants lie on a second side of the y-axis, and the first and second quadrants line on a first side of the x-axis, and the third and fourth quadrants lie on a second side of the x-axis, and wherein the y-axis is orthogonal to the x-axis

and the first measurement cell lies in the first quadrant, the second measurement cell lies in the second quadrant, the third measurement cell lies in the third quadrant, and the fourth measurement cell lies in the fourth quadrant, wherein each of the first, second, third and fourth measurement cells comprises:

- a mass element which is mobile in the y-direction, and
- a first fixed structure which comprises a first anchor point and a second fixed structure which comprises a second anchor point,

wherein the mass element in each of the first, second, third and fourth measurement cells forms a first capacitor with the first fixed structure, and the capacitance of the first capacitor increases when said mass element moves in a positive y-direction, and decreases when said mass element moves in a negative y-direction, which is opposite to the positive y-direction, and the mass element in each of the first, second, third and fourth measurement cells forms a second capacitor with the second fixed structure, and the capacitance of the second capacitor increases when said mass element moves in the negative y-direction, and decreases when said mass element moves in the positive y-direction, and each of the first, second, third and fourth measurement cells comprises a central line, and the first and second anchor points are on opposite sides of the central line in each of the first, second, third and fourth measurement cells, and

- the placement of the first and second anchor points with respect to the central line in the first and third measurement cells is the same,
- the placement of the first and second anchor points with respect to the central line in the second and fourth measurement cells is the same,
- the placement of the first and second anchor points with respect to the central line in the first measurement cell is opposite to the placement of the first and second capacitors with respect to the central line in the second measurement cell.

2.  An accelerometer according to claim 1, wherein the central line is parallel to the y-axis, and

- the first anchor point in the third measurement cell faces the first anchor point in the fourth measurement cell across the y-axis,
- the first anchor point in the fourth measurement cell faces the second anchor point in the first measurement cell across the x-axis,
- and the second anchor point in the first measurement cell faces the second anchor point in the second measurement cell across the y-axis.

3.  An accelerometer according to claim 1, wherein the central line is parallel to the x-axis, and

- the first anchor point in the first measurement cell faces the first anchor point in the fourth measurement cell across the x-axis,
- the first anchor point in the first measurement cell faces the second anchor point in the second measurement cell across the y-axis,
- and the second anchor point in the third measurement cell faces the second anchor point in the second measurement cell across the x-axis.

4.  An accelerometer according to any preceding claim, wherein each first capacitor comprises a first set of fixed combs on the first fixed structure and a first set of movable combs on the mass element, and the first sets of fixed and movable combs are oriented in the y-direction and interdigitated with each other, and each second capacitor comprises a second set of fixed combs on the second fixed structure and a second set of movable combs on the mass element, and the second sets of fixed and movable combs are oriented in the y-direction and interdigitated with each other.

5.  An accelerometer according to any of claims 1-4, wherein each first capacitor comprises a first set of fixed combs on the first fixed structure and a first set of movable combs on the mass element, and the first sets of fixed and movable combs are oriented in the x-direction and interdigitated with each other, and each second capacitor comprises a second set of fixed combs on the second fixed structure and a second set of movable combs on the mass element, and the second sets of fixed and movable combs are oriented in the x-direction and interdigitated with each other.

6.  An accelerometer according to any of claims 1-4, wherein each first capacitor comprises a first set of fixed combs on the first fixed structure and a set of movable combs on the mass element, and each second capacitor comprises a second set of fixed combs on the second fixed structure and the set of movable combs on the mass element, and the first and second sets of fixed combs and the set of movable combs are oriented in the x-direction, and each movable comb in the set of movable combs is flanked one side by a comb from the first set of fixed combs and flanked on the other side by a comb from the second set of fixed combs.

7. An accelerometer according to any preceding claim, wherein the capacitance of each first capacitor in each measurement cell is substantially equal to the capacitance of the second capacitor in the same measurement cell when the mass element in said measurement cell is in its rest position.

8. An accelerometer according claim 7, wherein the capacitances of all first and second capacitors in the first, second, third and fourth measurement cells are substantially equal when all mass elements are in their rest positions.

9. An accelerometer according to any preceding claim, wherein the structural patterns of the first and second capacitors in the first measurement cell are together substantially reflection-symmetric with the structural patterns of the first and second capacitors in the second measurement cell with respect to the y-axis, and the structural patterns of the first and second capacitors in the third measurement cell are together substantially reflection-symmetric with the structural patterns of the first and second capacitors in the fourth measurement cell with respect to the y-axis.

10. An accelerometer according to any preceding claim, wherein the structural patterns of the first and second capacitors in the first measurement cell are together substantially reflection-symmetric with the structural patterns of the first and second capacitors in the fourth measurement cell with respect to the x-axis, and the structural patterns of the first and second capacitors in the second measurement cell are together substantially reflection-symmetric with the structural patterns of the first and second capacitors in the third measurement cell with respect to the x-axis.

11. An accelerometer according to any preceding claim, wherein the device layer is made of silicon.

12. An accelerometer according to any preceding claim, wherein the mass element surrounds the first and second fixed structures in the xy-plane in each of the first, second, third and fourth measurement cells.

Fig. 1a

Fig. 1b

Fig. 1c

Fig. 2a

Fig. 2b

Fig. 2c

Fig. 2d

Fig. 2e

y
x

19

10

11

13

22

16

18

15

17

21

12

Fig. 2f

y
x

11

19

10

12    15    17    15    12

18

12    16          16    12

Fig. 2g

Fig. 3a

Fig. 3b

Fig. 3c

Fig. 3d

Fig. 3e

Fig. 3f

Fig. 4

Fig. 5

Fig. 6

# EUROPEAN SEARCH REPORT

**Application Number**

EP 24 21 7841

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2016/377649 A1 (RYTKÖNEN VILLE-PEKKA [FI]) 29 December 2016 (2016-12-29) | 1-3,7-12 | INV.<br>G01P15/125 |
| Y | * paragraphs [0002], [0039], [0040], [0055] - [0057], [0067]; figures 1-10 * | 4-6 | G01P15/18 |
| X | ----- <br>WO 2024/153875 A1 (TRONICS MICROSYSTEMS [FR]) 25 July 2024 (2024-07-25) | 1-12 | ADD.<br>G01P15/08 |
| Y | * pages 1, 9-12; figures 1-10 * | 4-6 | |
| A | ----- <br>US 2016/356806 A1 (MALVERN ALAN RICHARD [GB] ET AL) 8 December 2016 (2016-12-08) <br>* the whole document * <br>----- | 1-12 | |

TECHNICAL FIELDS
SEARCHED (IPC)

G01P
B82B

The present search report has been drawn up for all claims

| Place of search | Date of completion of the search | Examiner |
|---|---|---|
| Munich | 6 May 2025 | Schwarz, Cornelia |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 4 756 434 A1**

## ANNEX TO THE EUROPEAN SEARCH REPORT
## ON EUROPEAN PATENT APPLICATION NO.

EP 24 21 7841

06-05-2025

| Patent document cited in search report | Publication date | Patent family member(s) | | Publication date |
|---|---|---|---|---|
| US 2016377649 A1 | 29-12-2016 | CN | 107771287 A | 06-03-2018 |
| | | EP | 3314270 A1 | 02-05-2018 |
| | | FI | 127000 B | 15-09-2017 |
| | | JP | 6512313 B2 | 15-05-2019 |
| | | JP | 2018528399 A | 27-09-2018 |
| | | TW | 201708821 A | 01-03-2017 |
| | | US | 2016377649 A1 | 29-12-2016 |
| | | WO | 2016207800 A1 | 29-12-2016 |
| WO 2024153875 A1 | 25-07-2024 | FR | 3144989 A1 | 19-07-2024 |
| | | WO | 2024153875 A1 | 25-07-2024 |
| US 2016356806 A1 | 08-12-2016 | CN | 106030314 A | 12-10-2016 |
| | | EP | 3108261 A1 | 28-12-2016 |
| | | GB | 2523320 A | 26-08-2015 |
| | | JP | 6461180 B2 | 30-01-2019 |
| | | JP | 2017506343 A | 02-03-2017 |
| | | KR | 20160120734 A | 18-10-2016 |
| | | US | 2016356806 A1 | 08-12-2016 |
| | | WO | 2015124910 A1 | 27-08-2015 |

EPO FORM P0459

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 10324106 B